# EUROPEAN PATENT APPLICATION

(11) **EP 1 662 591 A2**
(43) Date of publication of application: **31.05.2006**
(21) Application number: 05111166.4
(22) Date of filing: 23.11.2005
(51) Int. Cl.: H01L 51/52

(54) **An OLED device with double-side Display**

(30) Priority: 30.11.2004 CN 200410097565
(71) Applicant: BenQ Mobile GmbH & Co. oHG, 81667 München (DE); BenQ Corporation, Gueishan Taoyuan 333 (TW)
(72) Inventor: Chen, Zhuo, 100037, Beijing (CN)
(74) Representative: Epping - Hermann - Fischer

(57) **Abstract**

The present invention provides an OLED device with double-side display, which comprises at least a transparent conductive glass anode (52), a cathode (57) opposing the transparent conductive glass anode, and an organic light-emitting layer (55) arranged between the transparent conductive glass anode (52) and the cathode (57); a driving voltage (59) is applied between the transparent conductive glass anode (52) and the cathode (57) to stimulate the organic light-emitting layer (55) to emit light, wherein the cathode (57) can also be made of transparent conductive glass, therefore realizing double-side display for the OLED device.

## Description

### Technical field

The present invention relates to an Organic Light-Emitting Diode (OLED) device, and more particularly to an OLED device capable of double-side display.

### Technical background

Compared with a Liquid Crystal Display (LCD) device which has now become more mainstream, the OLED device has greater advantages: in terms of volume, it is lighter than an LCD due to the fact that the OLED itself is able to emit light and thus neither backlight lamp nor external lamplight resource is needed. The thickness of an OLED panel is generally about 1mm-2mm, which is usually one third that of an ordinary color LCD and a half thinner than most black and white LCDs, and so a display of 3mm-4mm thickness can be manufactured easily; further, having excellent flexibility, the OLED can be folded and bent, thus giving an extremely broad scope of application. In terms of angle of view, the OLED has an extremely large angle of visibility, with which more than 160 degrees can be reached in both row and column without distortion of the images, which distinguishes the light-emitting source of the OLED from that of the LCD (the former is a radioactive substance, whereas the latter is a mapping substance), thus the inherent disadvantage of a small angle of view in the LCD can be obviated. In terms of response time, due to being solid, the OLED has a response speed 100-1000 times quicker than an LCD, completely avoiding the delay problem of an LCD and displaying the images more quickly and more smoothly. In terms of efficacy, the OLED can reach its optimal working status under only a 2V-10V voltage and, since it has no need of any backlight lamps, the OLED has lower power consumption than an LCD, thus improving the battery life. In terms of cost, the OLED is an artificial super thin organic film layer, which does not require a vacuum environment for its manufacture, and the OLED does not contain any unfixed materials either, thus having a low manufacturing cost, and at the same time no costly semi-conductor manufacturing and processing procedure has to be performed.

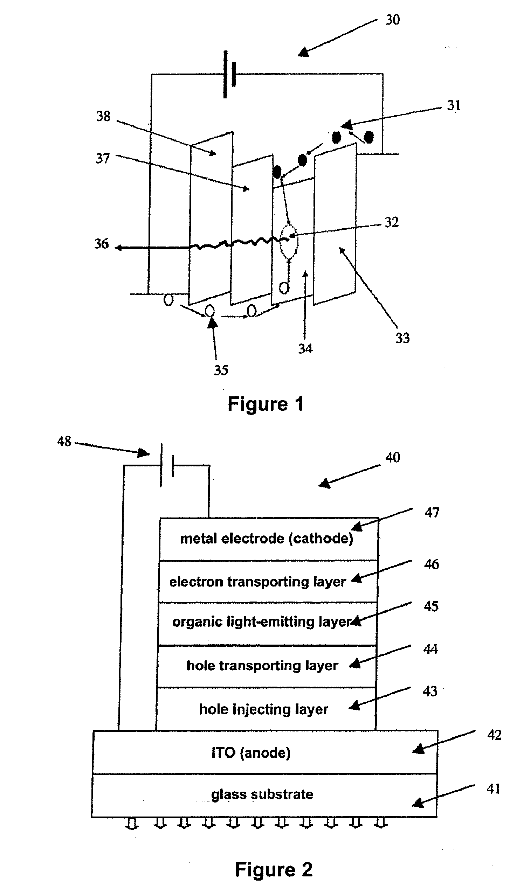

The principle of the simplest OLED is shown in fig. 1. In the OLED 30, an organic light-emitting layer 34 having light-emitting property is arranged between the anode and the cathode of the power supply. By applying a voltage 38, hole 35 is injected from the hole injecting zone 38 and transported through the hole transporting layer 37, and electron 31 is injected from the cathode and transported through the electron transporting layer 33. Said electron 31 and hole 35 will combine during transmission, thus bringing organic light-emitting molecule 32 to a state of excitation. When the molecule returns to ground state by releasing energy, a portion of the energy will be released as a photon 36 by means of internal transformation, thereby realizing light emission.

The industry usually employs a metal electrode as the cathode of the OLED, and transparent conductive glass (Indium-Tin Oxide (ITO)) as the anode at the same time. As shown in fig. 2, the basic structure of the prior art OLED device 40 includes a glass substrate 41, an ITO anode 42, a hole injecting layer (HIL) 43, a hole transporting layer (HTL) 44, an organic light-emitting layer (EML) 45, an electron transporting layer 46 and a metal electrode cathode 47 respectively arranged in sequence. The energy released for molecules in the organic light-emitting layer to restore the ground state from the excitation state is converted into light energy to spread outwards from the glass substrate.

As described above, all OLEDs in the prior art can only emit light from the transparent ITO anode side, while the cathode side of the metal electrode can only act as the back of OLED devices. The prior art OLED devices, such as devices disclosed in U.S. Pat. No. 6586764, U.S. patent application No. 20020094422, and Chinese patent application No. 02109031.9, etc., can only realize single side display. However, in certain circumstances, a user may wish to display the same information on the front side as well as the rear side of an OLED device, such as a portable communication device, a notebook computer, and a large-scale outdoor display screen, etc., but it is obvious that the OLED devices in the prior art are unable to meet such requirements.

In order to meet the user's requirements as mentioned above, OLED devices with double-side display are beginning to appear on the market. However, said OLED devices with double-side displays are of a design with a double-layer structure, i.e. two sets of OLED display units are combined back to back to realize double-side display for said OLED devices. Such design leads to double-side display devices having a complex structure, increased thickness and weight, and a much higher cost.

### (3) Summary of the invention

A main object of the present invention is to provide a simply-structured OLED device with double-side display.

Another object of the present invention is to provide a thinner and lighter OLED device with double-side display.

A further object of the present invention is to provide an OLED device with double-side display, having a lower manufacturing cost.

To achieve the objects mentioned above, the present invention provides an OLED device with double-side display which comprises at least a transparent conductive glass (ITO) anode, a cathode opposing the transparent conductive glass anode and an organic light-emitting layer arranged between the transparent conductive glass anode and the cathode; a driving voltage is applied between the transparent conductive glass anode and the cathode to stimulate the organic light-emitting layer to emit light; wherein said cathode is also made of transparent conductive glass.

The OLED device with double-side display may further comprise:
a hole injecting layer (HIL) and a hole transporting layer (HTL) respectively arranged in sequence between the transparent conductive glass anode and the organic light-emitting layer; an electron transporting layer arranged between the transparent conductive glass cathode and the organic light-emitting layer; a glass substrate arranged on the outer side of each of the transparent conductive glass anode and transparent conductive glass cathode. In addition, the OLED device with double-side display may further comprise embedded software and a corresponding drive circuit, arranged to mirror the image for one side of the OLED device with double-side display.

The present invention is mainly characterized in that: a transparent conductive glass cathode is used to replace the nontransparent metal cathode of the prior art, thus overcoming the disadvantage that OLED devices in the prior art can only emit light from a single side, or can realize double-side display only by way of a double-layer structure.

It can be seen that the OLED device with double-side display provided by the present invention has the following advantages:
(a) Having a simple structure, only the metal cathode of the OLED device in the prior art needs to be replaced with a transparent conductive glass cathode, and the relevant circuit does not need to be altered to a great extent;
(b) Being thinner and lighter, since there is no need for the double-layer structure of the OLED device in the prior art, the thickness and weight will hardly increase; and
(c) Having lower manufacturing costs, there is no need to adopt two sets of OLED display units, thereby effectively reducing the cost.

### Brief description of the drawings

Fig. 1 is a diagram of the light-emitting principle of the OLED device in the prior art;
Fig. 2 is a schematic diagram of the basic structure of the OLED device in the prior art;
Fig. 3 is a schematic diagram of the basic structure of the OLED device with double-side display according to the present invention.

### Detailed description of the embodiments

The present invention will be described below in detail with reference to the accompanying figures.

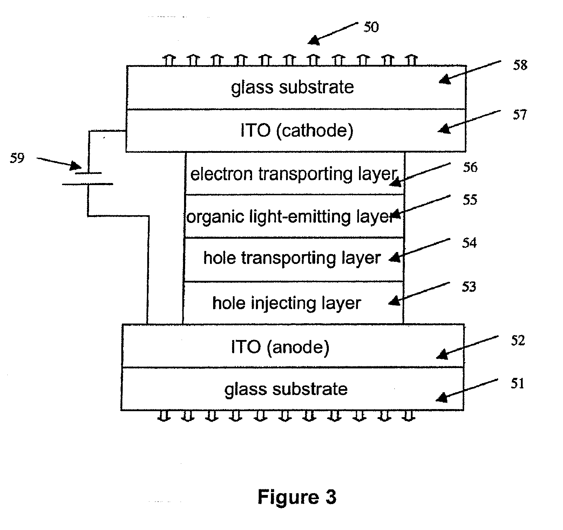

Referring to fig. 3, an OLED device with double-side display 50 according to the present invention comprises at least a transparent conductive glass (Indium-Tin Oxide; ITO) anode 52, a transparent ITO cathode 57 opposing the transparent ITO anode, and an organic light-emitting layer (EML) 55 arranged between the ITO anode 52 and the ITO cathode 57.

The OLED device with double-side display 50 further comprises a hole injecting layer (HIL) 53 and a hole transporting layer (HTL) 54 arranged between the ITO anode 52 and the organic light-emitting layer 55, wherein the hole injecting layer (HIL) 53 is adjacent the ITO anode, the hole transporting layer is adjacent the organic light-emitting layer 55; an electron transporting layer 56 is arranged between the ITO cathode and the organic light-emitting layer 55.

The OLED device with double-side display 50 further comprises glass substrates 51, 57 respectively arranged on the outer sides of the ITO anode 52 and the ITO cathode 57, the visible light emitted by the organic light-emitting layer 55 can carry out double-side display from both the front side and the rear side by means of these two glass substrates 51, 57. A driving voltage 59 is applied between the ITO anode 52 and the ITO cathode 57.

The glass substrates 51, 57 may also be flexible substrates so as to increase the flexibility of the OLED device with double-side display 50. The ITO anode 52 is plated on the glass substrate 51, serving as the hole emitting material of the OLED device with double-side display 50. A layer of copper phthalocyanine may be further covered on the ITO anode 52, so as to passivate the ITO anode 52 and provide a higher stability. Driven by the driving voltage 59, in general 2-10 volts, the hole produced by the ITO anode 52 is injected from the hole injecting layer, and then transported through the hole transporting layer 54 to the organic light-emitting layer 55. The hole transporting layer 54 is made of a hole transporting material having high mobility under the drive of an electric field. In order to prevent the hole transporting material from giving rise to the problem of recrystallization after a long time of aging, the thin-film morphology formed naturally, having a high heat-resistant stability (high Glass Transition Temperature Tg) and lower energy barrier with the ITO anode 52, should preferably be chosen as the hole transporting material. The organic light-emitting layer 55 may be made of low molecular weight or high molecular weight organic light-emitting material having a conjugate chemical constitution, and is formed on the hole transporting layer 54 by a thermal evaporation method (suitable for the low molecular weight organic light-emitting material) or spin-coating method (suitable for the high molecular weight organic light-emitting material).

In a similar way, the ITO cathode 57 is also plated on the glass substrate 57, opposing the ITO anode 52, and serving as the electron emitting material of the OLED device with double-side display 50. An electron transporting layer 56 is arranged between the ITO cathode 57 and the organic light-emitting layer 55. Driven by the voltage 59, the electron emitted by the ITO cathode 57 is injected into the electron transporting layer 56, and then transported through the electron transporting layer 56 to the organic light-emitting layer 55.

As mentioned above, driven by the voltage 59, the hole and electron are respectively injected into the hole transporting layer 53 and electron transporting layer 56 from the ITO anode 52 and the ITO cathode 57, the electron and hole respectively pass through the hole transporting layer 53 and electron transporting layer 56 to transfer to the organic light-emitting layer 55, where they will meet each other, thus exciting the molecules of the organic light-emitting material which forms the organic light-emitting layer 55. The energy released for molecules in the organic light-emitting layer to restore the ground state from the excitation state is converted into visible light, which can spread outwards from both the ITO anode 52 side and the ITO cathode side at the same time, thus realizing double-side display for the OLED device 50.

In the present invention, both the anode and cathode of the OLED device are made of transparent ITO, which allows the visible light emitted by the organic light-emitting layer to spread outwards from both sides of the OLED device to realize double-side display, thus overcoming the disadvantage in the prior art that light can only spread from the ITO anode side, that is, light can only be emitted from a single side due to the fact that in the prior art a nontransparent metal cathode is used, which reflects the visible light emitted by its organic light-emitting layer.

Moreover, in the above mentioned double-side display, the images observed from both sides of the OLED device 50 are the same, which leads to image display from one side being laterally inverted, opposite to the normal image direction. In a further embodiment according to the OLED device with double-side display of the present invention, embedded software and its corresponding drive circuit may be included instead to mirror the image of one side of the OLED device with double-side display, thereby making the image direction of that side the same as the normal image direction. Since the relevant software to realize a mirrored image and its corresponding circuit are relatively well-documented in the prior art, no detail thereof will be disclosed

## Claims

1. An OLED (Organic Light-Emitting Diode) device with double-side display, said OLED device comprising at least a transparent conductive glass (Indium-Tin Oxide ITO) anode, a cathode opposing the transparent conductive glass anode, and an organic light-emitting layer arranged between the transparent conductive glass anode and the cathode; a driving voltage is applied between the transparent conductive glass anode and the cathode to stimulate the organic light-emitting layer to emit light, wherein said cathode is also made of transparent conductive glass.

2. The OLED device with double-side display as claimed in claim 1, **characterized in that** a hole injecting layer (HIL) and a hole transporting layer (HTL) are respectively arranged in sequence between the transparent conductive glass anode and the organic light-emitting layer.

3. The OLED device with double-side display as claimed in claim 1, wherein an electron transporting layer (ETL) is arranged between the transparent conductive glass cathode and the organic light-emitting layer.

4. The OLED device with double-side display as claimed in claim 2 or 3, **characterized in that** a glass substrate is provided on the outer side of each of the transparent conductive glass anode and transparent conductive glass cathode.
